# EUROPÄISCHE PATENTANMELDUNG

(11) **EP 0 817 325 A1**
(43) Veröffentlichungstag der Anmeldung: **07.01.1998**
(21) Anmeldenummer: 97109695.3
(22) Anmeldetag: 13.06.1997
(51) Int. Cl.: H01R 23/68, G02F 1/1345

(54) **Kontaktvorrichtung zur elektrischen Verbindung einer Leiterplatte mit einer Flüssigkristallanzeigeplatte**

(30) Priorität: 01.07.1996 DE 19626377
(71) Anmelder: OTTO DUNKEL GMBH FABRIK FÜR ELEKTROTECHNISCHE GERÄTE, 84453 Mühldorf (DE)
(72) Erfinder: Jacobi, Wolfgang, Dr.-Ing., 81925 München (DE)
(74) Vertreter: Patentanwälte Leinweber & Zimmermann

(57) **Zusammenfassung**

Die Kontaktvorrichtung dient der elektrischen Verbindung einer Leiterplatte (7) mit einer sich etwa parallel zu ihr erstreckenden, durch eine weitere Leiterplatte bzw. vorzugsweise durch eine Flüssigkristallanzeigeplatte (LCD) gebildete Platte (4) über ein im Querschnitt etwa U-förmig ausgebildetes Kontaktstück (1). Dieses erfaßt die randseitig eine Vielzahl von Anschlußkontaktstellen aufweisende Platte (4) im Bereich dieses Randes zwischen seinen Schenkeln (2, 3). Der erste Schenkel (2) ist innenseitig mit einer der Zahl und Anordnung der Anschlußkontaktstellen entsprechenden Mehrzahl nebeneinander angeordneter Kontaktelemente (6) versehen. Diese stehen mit den Anschlußkontaktstellen der in gestecktem Zustand befindlichen Platte (4) in Berührung und stellen jeweils im Bereich der Außenseite des zweiten Schenkels (3) eine Verbindung zu einer der an der Außenseite der Leiterplatte (7) verlaufenden Leiterplatten-Kontaktbahnen her. Eine mit geringerem Aufwand und Platzbedarf herstellbare Vorrichtung ergibt sich dadurch, daß die an der Außenseite des zweiten Schenkels (3) des Kontaktstücks (1) auslaufenden Kontaktelemente (6) mit den Leiterplatten-Kontaktbahnen unmittelbar in Berührung stehen und daß das Kontaktstück (1) an der Außenseite des innenseitig mit den nebeneinander angeordneten Kontaktelementen (6) bestückten ersten Schenkels (2) mit einer weichen Elastomerschicht (12) versehen ist.

## Beschreibung

Die Erfindung bezieht sich auf eine Kontaktvorrichtung zur elektrischen Verbindung einer Leiterplatte mit einer sich etwa parallel zu ihr erstreckenden, durch eine weitere Leiterplatte bzw. vorzugsweise durch eine Flüssigkristallanzeigeplatte (LCD) gebildete Platte über ein im Querschnitt etwa U-förmig ausgebildetes Kontaktstück, das die randseitig eine Mehrzahl von Anschlußkontaktstellen aufweisende Platte im Bereich dieses Randes zwischen seinen Schenkeln erfaßt, von denen der erste Schenkel innenseitig mit einer der Zahl und Anordnung der Anschlußkontaktstellen entsprechenden Mehrzahl nebeneinander angeordneter Kontaktelemente versehen ist, die mit den Anschlußkontaktstellen der in gestecktem Zustand befindlichen Platte in Berührung stehen und jeweils im Bereich der Außenseite des zweiten Schenkels eine Verbindung zu einer der an der Außenseite der Leiterplatte verlaufenden Leiterplatten-Kontaktbahnen herstellen.

Bei bekannten Kontaktvorrichtungen diese Art, wie sie insbesondere in Handys mit LCD-Platte Einsatz finden, ist es erforderlich, zwischen die an der Außenseite des zweiten Schenkels des Kontaktstücks auslaufenden Kontaktelemente und den die Leiterplatten-Kontaktbahnen aufweisenden Bereich der Außenseite der Leiterplatte einen sogenannten Zebra-Block zwischenzuschalten, d. h. einen Block aus sandwichartig aufeinanderfolgenden, abwechselnd leitenden und nichtleitenden Elastomerschichten. Über die leitenden Schichten dieses Zebra-Blocks läßt sich eine zufriedenstellende Verbindung der Kontaktelemente des Kontaktstücks mit den Leiterplatten-Kontaktbahnen auch dann erreichen, wenn die LCD-Platte und die Leiterplatte geringfügig versetzt zueinander zusammengeführt werden sollte. Vor allem sorgt der elastisch nachgiebige Zebra-Block auch dann für einen einwandfreien Kontakt, wenn die Ebene der LCD-Platte in gesteckten Zustand in bezug zur Ebene der Leiterplatte nicht absolut parallel verlaufen, sondern vielmehr einen kleinen Winkel von wenigen Grad mit letzterer einschließen sollte.

Insbesondere unter beengten Platzbedingungen im Gehäuse von Handys hat sich die Höhe dieser Kontaktvorrichtung als sehr nachteilig herausgestellt. Hinzu kommt der erforderliche kostspielige Aufwand aufgrund der notwendigen Einschaltung des elastischen Zebra-Blocks.

Ausgehend von diesem Stand der Technik liegt der Erfindung die Aufgabe zugrunde, die Kontaktvorrichtung der eingangs genannten Art so weiter auszugestalten, daß sich eine weniger verwickelte und somit mit geringerem Aufwand zu fertigende, im Bedarfsfall kompakter herstellbare Ausführung ergibt, bei der dennoch Winkelabweichungen der LCD-Anzeigevorrichtung relativ zur Leiterplatte von einigen Grad möglich sind und darüber hinaus die Qualität der Übertragung elektrischer Signale verbessert ist.

Die Kontaktvorrichtung nach der Erfindung, bei der diese Aufgabe gelöst ist, zeichnet sich im wesentlichen dadurch aus, daß die an der Außenseite des zweiten Schenkels des Kontaktstücks auslaufenden Kontaktelemente mit den Leiterplatten-Kontaktbahnen unmittelbar in Berührung stehen und daß das Kontaktstück an der Außenseite des innenseitig mit den nebeneinander angeordneten Kontaktelementen bestückten ersten Schenkels mit einer weichen Elastomerschicht versehen ist. Diese Vorrichtung kommt somit mit einem Bauteil weniger aus, und es entfällt eine Trennebene, was mit einem besseren Stromübergang verbunden ist. Wird eine derartige Kontaktvorrichtung fest gegen die Leiterplatte gedrückt und mit den auslaufenden Kontaktelementen über die Elastomerschicht in fester Anlage an den Leiterplattenkontaktbahnen gehalten, dann wird aufgrund einer Schrägstellung der durch die LCD-Platte gebildeten Platte in bezug auf die Leiterplatte eine entsprechende Schrägstellung des Kontaktstücks herbeigeführt, da die Elastomerschicht infolge der ungleichmäßigen Druckbeaufschlagung ungleichmäßig komprimiert und damit verformt wird. Sie sorgt auf diese Weise für einen Ausgleich von Form- und Lagetoleranzen.

Dabei hat es sich als in baulicher Hinsicht sehr günstig erwiesen, wenn der erste Schenkel des U-förmig ausgebildeten Kontaktstücks unterhalb des die weiche Elastomerschicht abstützenden Bereichs mit Durchbrüchen versehen ist, durch die hindurch sich die nebeneinander angeordneten Kontaktelemente zu den Anschlußkontaktstellen im Bereich der Platte erstrecken.

Der erleichterten Montage ist es dienlich, wenn das U-förmige Kontaktstück eine seinen Abmessungen angepaßte, seiner Lagesicherung dienende Ausnehmung in einer sich auf der Leiterplatte abstützenden Positionsplatte durchsetzt.

In weiterer Ausgestaltung ist es dabei förderlich, wenn der erste Schenkel des U-förmigen Kontaktstücks eine sich über einen Teil der Schenkellänge erstreckende Abstufung aufweist, in der sich die Platte mit ihrer den Anschlußkontaktstellen abgelegenen Randaußenseite abstützt.

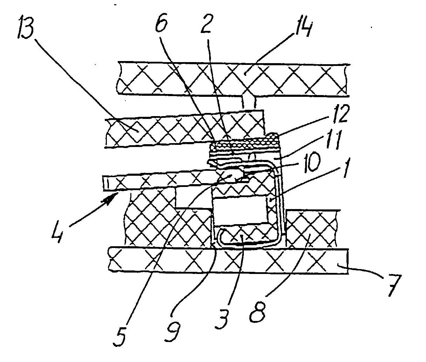

Weitere Einzelheiten, Vorteil und Merkmale der Erfindung ergeben sich aus der folgenden Beschreibung anhand der beigefügten Zeichnung, in der die erfindungsgemäße Kontaktvorrichtung in einer schematischen Schnittdarstellung veranschaulicht ist.

Wie ersichtlich, umfaßt die Kontaktvorrichtung ein im Querschnitt U-förmiges Kontaktstück 1, das zwischen seinen Schenkeln 2 und 3 eine Flüssigkristallanzeigeplatte, kurz LCD-Platte 4 erfaßt, und zwar im Bereich des Randes 5 dieser Platte, an dem sich in bekannter Weise eine Mehrzahl von nicht näher dargestellten Anschlußkontaktstellen aufweist. Der obere, erste Schenkel 2 des Kontaktstücks 1 ist innenseitig mit einer der Zahl und Anordnung dieser Anschlußkontaktstellen entsprechenden Vielzahl nebeneinander angeordneter Kontaktelemente 6 versehen. Diese stehen in gestecktem Zustand der LCD-Platte 4 mit ihren Anschlußkontaktstellen in Berührung. Die Kontaktelemente 6 laufen an der Außenseite des zweiten Schenkels 3 des Kontaktstücks 1 aus. Dort stehen sie mit nicht näher veranschaulichten Kontaktbahnen auf einer Leiterplatte 7 in Berührung. Für eine einwandfreie Positionierung und Lagesicherung des Kontaktstücks 1 sorgt eine sich auf der Leiterplatte 7 abstützende Positionsplatte 8 mit einer Ausnehmung 9, deren Abmessungen denen des Kontaktstücks 1 angepaßt sind.

Der Zeichnung ist entnehmbar, daß der erste Schenkel 2 des U-förmigen Kontaktstücks 1 eine sich über einen Teil der Schenkellänge erstreckende Abstufung 10 aufweist, in der sich die LCD-Platte 4 abstützt, und zwar mit ihrer den Anschlußkontaktstellen abgelegenen Randaußenseite.

Der erste obere Schenkel 2 ist ferner mit Durchbrüchen 11 versehen, durch die hindurch sich die nebeneinander angeordneten Kontaktelemente 6 zu den Anschlußstellen im Bereich der LCD-Platte 4 erstrecken. An der Außenseite des oberen Schenkels 2 ist das U-förmige Kontaktstück 1 mit einer Auflage einer weichen Elastomerschicht 12 versehen, auf der sich eine durchsichtige Acrylglasplatte 13 abstützt, so daß letztere mit ihrem Randbereich über die Elastomerschicht 12 zwischen dem oberen Schenkel 2 des U-förmigen Kontaktstücks 1 und einem Gehäuseoberteil 14, beispielsweise dem im geschlossenen Zustand befindlichen Oberteil eines Handygehäuses eingespannt ist.

## Patentansprüche

1. Kontaktvorrichtung zur elektrischen Verbindung einer Leiterplatte (7) mit einer sich etwa parallel zu ihr erstreckenden durch eine weitere Leiterplatte bzw. vorzugsweise durch eine Flüssigkristallanzeigeplatte (LCD) gebildete Platte (4) über ein im Querschnitt etwa U-förmig ausgebildetes Kontaktstück (1), das die randseitig eine Mehrzahl von Anschlußkontaktstellen aufweisende Platte (4) im Bereich dieses Randes zwischen seinen Schenkeln (2, 3) erfaßt, von denen der erste Schenkel (2) innenseitig mit einer der Zahl und Anordnung der Anschlußkontaktstellen entsprechenden Mehrzahl nebeneinander angeordneter Kontaktelemente (6) versehen ist, die mit den Anschlußkontaktstellen der in gestecktem Zustand befindlichen Platte (4) in Berührung stehen und jeweils im Bereich der Außenseite des zweiten Schenkels (3) eine Verbindung zu einer der an der Außenseite der Leiterplatte (7) verlaufenden Leiterplatten-Kontaktbahnen herstellen, dadurch gekennzeichnet, daß die an der Außenseite des zweiten Schenkels (3) des Kontaktstücks (1) auslaufenden Kontaktelemente (6) mit den Leiterplatten-Kontaktbahnen unmittelbar in Berührung stehen und daß das Kontaktstück (1) an der Außenseite des innenseitig mit den nebeneinander angeordneten Kontaktelementen (6) bestückten ersten Schenkels (2) mit einer weichen Elastomerschicht (12) versehen ist.

2. Kontaktvorrichtung nach Anspruch 1, dadurch gekennzeichnet, daß der erste Schenkel (2) des U-förmig ausgebildeten Kontaktstücks (1) unterhalb des die weiche Elastomerschicht (12) abstützenden Bereichs mit Durchbrüchen (11) versehen ist, durch die hindurch sich die nebeneinander angeordneten Kontaktelemente (6) zu den Anschlußkontaktstellen im Bereich der Platte (4) erstrecken.

3. Kontaktvorrichtung nach Anspruch 1 oder 2, dadurch gekennzeichnet, daß das U-förmige Kontaktstück (1) eine seinen Abmessungen angepaßte, seiner Lagesicherung dienende Ausnehmung (9) in einer sich auf der Leiterplatte (7) abstützenden Positionsplatte (8) durchsetzt.

4. Kontaktvorrichtung nach einem der Ansprüche 1 bis 3, dadurch gekennzeichnet, daß der erste Schenkel (2) des U-förmigen Kontaktstücks (1) eine sich über einen Teil der Schenkellänge erstreckende Abstufung (10) aufweist, in der sich die Platte (4) mit ihrer den Anschlußkontaktstellen abgelegenen Randaußenseite abstützt.
